(19) Europäisches Patentamt

European Patent Office

Office européen des brevets

(11) **EP 4 488 761 A1**

(12) **EUROPEAN PATENT APPLICATION**

(43) Date of publication:
**08.01.2025 Bulletin 2025/02**

(21) Application number: **23183982.0**

(22) Date of filing: **06.07.2023**

(51) International Patent Classification (IPC):
**G03F 7/20** *(2006.01)* **H01L 21/683** *(2006.01)*
**H01L 21/687** *(2006.01)*

(52) Cooperative Patent Classification (CPC):
**G03F 7/70708; H01L 21/6833**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **ASML Netherlands B.V.**
**5500 AH Veldhoven (NL)**

(72) Inventors:
• **POIESZ, Thomas**
**5500 AH Veldhoven (NL)**

• **VAN ROOIJ, René, Adrianus**
**5500 AH Veldhoven (NL)**
• **REIJNEN, Martinus, Cornelis**
**5500 AH Veldhoven (NL)**
• **VAN EDEN, Gustaaf, Galein**
**5500 AH Veldhoven (NL)**
• **ENGELEN, Johannes, Bernardus, Charles**
**5500 AH Veldhoven (NL)**

(74) Representative: **ASML Netherlands B.V.**
**Corporate Intellectual Property**
**P.O. Box 324**
**5500 AH Veldhoven (NL)**

(54) **ELECTROSTATIC CLAMP ARRANGEMENT**

(57) The present disclosure relates to an electrostatic clamp arrangement comprising a clamp member comprising at least one electrode and a first electrically conductive layer; a mounting member, comprising a second electrically conductive layer, upon which the clamp member is mounted; and a dielectric layer sandwiched between the first and second electrically conductive layers.

FIG. 3

## Description

<u>FIELD</u>

The present invention relates to an electrostatic clamping arrangement. In particular, the electrostatic clamping arrangement may be configured to clamp an object such as a lithographic substrate. The electrostatic clamping arrangement may form part of a lithographic apparatus or lithographic tool.

<u>BACKGROUND</u>

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

A substrate which is being patterned by a lithographic apparatus is held on a movable substrate table. The substrate table includes a clamping arrangement which is configured to securely hold the substrate on the substrate table whilst the substrate is being patterned, and then to allow the substrate to be removed from the substrate table once patterning has been completed. In an EUV system the clamping arrangement is an electrical (or electrostatic) clamp (conventional vacuum clamps cannot be used because the EUV lithographic apparatus uses a vacuum environment). A problem which may arise in relation to existing clamping arrangements is that if it is desired to accelerate the substrate table more quickly, the clamping arrangement will need to apply a greater clamping force to the substrate to prevent the substrate from moving relative to the substrate table when the substrate table is moved. The need for the clamping arrangement to apply a greater clamping force to the substrate may traditionally require increasing the size of the clamping arrangement and/or increasing the power supplied to the clamping arrangements. Such increased size and/or increased supplied power may not be feasible in all applications.

It may be desirable to address the above problem in a manner which is not disclosed or suggested by the prior art.

## SUMMARY

According to a first aspect of the invention there is provided an electrostatic clamp arrangement comprising: a clamp member comprising at least one electrode and a first electrically conductive layer; a mounting member, comprising a second electrically conductive layer, upon which the clamp member is mounted; and a dielectric layer sandwiched between the first and second electrically conductive layers.

The dielectric layer may be fixed to second electrically conductive layer.

The dielectric layer may be discontinuous.

The dielectric layer may be fixed to first electrically conductive layer.

The clamp member may comprise a main body which includes the at least one electrode, and a plurality of burls depending from the main body.

The first electrically conductive layer may be located on said plurality of burls.

The second electrically conductive layer may be formed of at least one of Chromium, Tungsten, Vanadium or Titanium.

The first electrically conductive layer may be formed of at least one of chromium nitride, silicon carbide, siliconized silicon carbide, conductive diamond, titanium nitride or doped chromium nitrate e.g. CrNAl.

The dielectric layer may be formed of at least one of silicon oxide, diamond, boron nitride, zircon oxide, aluminium nitride, silicon nitride, or aluminium oxide.

The electrostatic clamp arrangement may further comprise a power supply.

The power supply may be electrically connected to the at least one electrode.

The first electrically conductive layer may be electrically connected to ground.

The second electrically conductive layer may be at a set, floating or bias voltage.

The electrostatic clamp arrangement may further comprise a switch which is electrically connected to the second electrically conductive layer and to ground (or other set voltage - for example, as set by a power supply).

The switch may have a first configuration in which the switch does not electrically connect the second electrically conductive layer to ground (or other set voltage), and a second configuration in which the switch electrically connects the second electrically conductive layer to ground (or other set voltage). In the case where the second configuration of the switch electrically connects the second electrically conductive layer to ground, the switch may have a third configuration in which it electrically connects the second electrically conductive layer to said other set voltage.

The at least one electrode may comprise a first electrode and a second electrode.

The power supply may be connected to the first and second electrodes.

The power supply may be configured to place the first electrode at a first positive voltage and place the second electrode at a second negative voltage, wherein the first and second voltages are not the same such that there is an offset between the first and second voltages.

The second electrically conductive layer may be electrically connected to a power supply configured to place the second electrically conductive layer at a desired non-ground voltage.

The second electrically conductive layer may be discontinuous such that it comprises first and second electrically conductive portions that are electrically isolated from each other.

The second electrically conductive portion may be connected to electrical ground.

The first electrically conductive portion may be at a bias or set voltage.

The first electrically conductive portion may be electrically connected to a power supply to drive the first electrically conductive portion so that it is at a set voltage.

According to a second aspect of the invention there is provided a lithographic apparatus comprising an electrostatic clamp arrangement according to the preceding aspect.

The lithographic apparatus may further comprise an illumination system and a projection system.

According to a third aspect of the invention there is provided a method of operating an electrostatic clamp arrangement, the electrostatic clamp arrangement comprising: a clamp member comprising at least one electrode and a first electrically conductive layer; a mounting member, comprising a second electrically conductive layer; a dielectric layer; and a power supply; the method comprising: mounting the clamp member to the mounting member such that the dielectric layer is sandwiched between the first and second electrically conductive layers; electrically connecting the first electrically conductive layer to ground; and electrically connecting the power supply to the at least one electrode such that the power supply places the at least one electrode at a voltage and thereby produces and electrostatic force which urges the clamp member towards mounting member.

Features of different aspects of the invention may be combined together, where appropriate.

BRIEF DESCRIPTION OF THE DRAWINGS

Embodiments of the invention will now be described, by way of example only, with reference to the accompanying schematic drawings, in which:

- Figure 1 schematically depicts a lithographic system comprising a lithographic apparatus and a substrate table according to an embodiment of the invention;
- Figure 2 shows a schematic side view of a prior art clamp arrangement;
- Figure 3 shows a schematic side view of a clamp arrangement in accordance with an embodiment of the present invention;
- Figure 4 shows a schematic side view of a clamp arrangement in accordance with another embodiment of the present invention; and
- Figure 5 shows a schematic plan view of a conductive layer of a mounting member in accordance with an embodiment of the present invention.

DETAILED DESCRIPTION

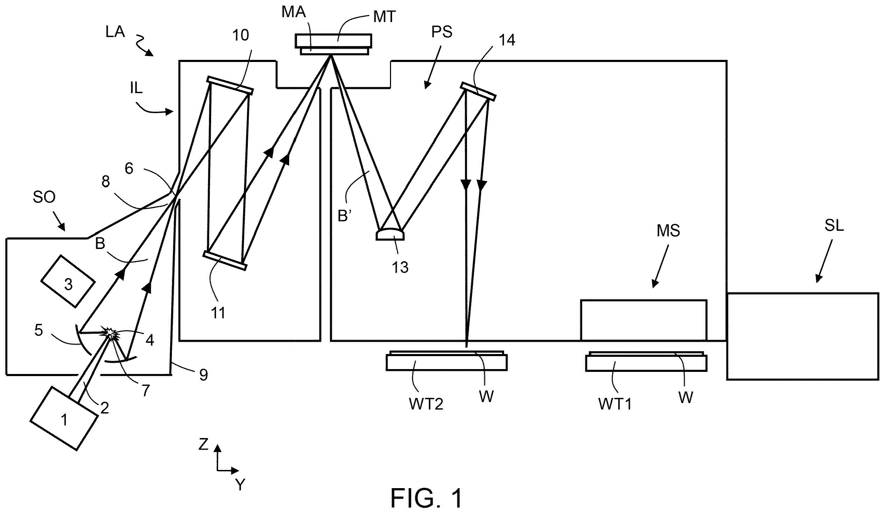

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS, a measurement system MS, and a substrate loading system SL. The lithographic system further comprises two substrate tables WT1, WT2 which are configured to support a substrate W. Each substrate table WT1, WT2 may be according to an embodiment of the invention. The support structure MT may be according to an embodiment of the invention. As explained further below, the substrate clamp may comprise an electrostatic clamp and a Johnsen-Rahbek clamp.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13, 14 which are configured to project the patterned EUV radiation beam B' onto the substrate W held by the substrate table WT2. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13, 14 in Figure 1, the projection system PS may include a different number of mirrors (e.g., six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the environment of the projection system PS (which may also contain the measurement system MS).

The radiation source SO shown in Figure 1 is, for example, of a type which may be referred to as a laser produced plasma (LPP) source. A laser system 1, which may, for example, include a $CO_2$ laser, is arranged to deposit energy via a laser beam 2 into a fuel, such as tin (Sn) which is provided from, e.g., a fuel emitter 3. Although tin is referred to in the following description, any suitable fuel may be used. The fuel may, for example, be in liquid form, and may, for example, be a metal or alloy. The fuel emitter 3 may comprise a nozzle configured to direct tin, e.g. in the form of droplets, along a trajectory towards a plasma formation region 4. The laser beam 2 is incident upon the tin at the plasma formation region 4. The deposition of laser energy into the tin creates a tin plasma 7 at the plasma formation region 4. Radiation, including EUV radiation, is emitted from the plasma 7 during de-excitation and recombination of electrons with ions of the plasma.

The EUV radiation from the plasma is collected and focused by a collector 5. Collector 5 comprises, for example, a near-normal incidence radiation collector 5 (sometimes referred to more generally as a normal-incidence radiation collector). The collector 5 may have a multilayer mirror structure which is arranged to reflect EUV radiation (e.g., EUV radiation having a desired wavelength such as 13.5 nm). The collector 5 may have an ellipsoidal configuration, having two focal points. A first one of the focal points may be at the plasma formation region 4, and a second one of the focal points may be at an intermediate focus 6, as discussed below.

The laser system 1 may be spatially separated from the radiation source SO. Where this is the case, the laser beam 2 may be passed from the laser system 1 to the radiation source SO with the aid of a beam delivery system (not shown) comprising, for example, suitable directing mirrors and/or a beam expander, and/or other optics. The laser system 1, the radiation source SO and the beam delivery system may together be considered to be a radiation system.

Radiation that is reflected by the collector 5 forms the EUV radiation beam B. The EUV radiation beam B is focused at intermediate focus 6 to form an image at the intermediate focus 6 of the plasma present at the plasma formation region 4. The image at the intermediate focus 6 acts as a virtual radiation source for the illumination system IL. The radiation source SO is arranged such that the intermediate focus 6 is located at or near to an opening 8 in an enclosing structure 9 of the radiation source SO.

The measurement system MS of the lithographic apparatus is configured to perform measurements of properties of a substrate W held on a substrate table WT1. The measurement system MS comprises an alignment system, which is configured to measure the positions of alignment marks on the substrate with reference to alignment marks on the substrate table WT1. The measurement system further comprises a level sensor which is configured to measure the topology of the substrate W. These measured properties are used to ensure accuracy when a pattern is subsequently projected onto the substrate W.

The lithographic apparatus LA is a dual-stage lithographic apparatus. That is, the lithographic apparatus includes two substrate tables WT1, WT2 and is configured such that a substrate W held on one of the substrate tables WT1 is measured by the measurement system MS simultaneously with a pattern being applied to a substrate W held on the other substrate table WT2. For ease of terminology, one of the substrate tables WT1 may be referred to as a first substrate table, and the other substrate table WT2 may be referred to as a second substrate table. Dual-stage lithographic apparatus advantageously provide higher throughput (i.e. exposure of substrates per hour) than single stage lithographic apparatus (which generally perform measurements simultaneously with exposure of a substrate). Once the substrate W held on the first substrate table WT1 has been measured, and the substrate W held on the second substrate table WT2 has been exposed, the substrate table WT1 supporting the measured substrate W is moved to be beneath the projection system PS. At the same time, the exposed substrate W supported by the second substrate table WT2 is moved to the substrate loading system SL.

The substrate loading system SL includes a substrate handler (not depicted) which is configured to remove the patterned substrate W from the second substrate table WT2, and then load a new substrate to be patterned onto the second substrate table. Once the substrate has been loaded onto the second substrate table WT2, the measurement system MS is used to measure alignment mark positions and the topology of the substrate. Simultaneously, the substrate W held on the first substrate table WT1 is exposed by the lithographic apparatus.

The above method is repeated many times in order to expose many substrates using the lithographic apparatus.

Each substrate table WT1, WT2 comprises a substrate clamp arrangement according to an embodiment of the invention. The substrate clamp arrangement is switched off before an exposed substrate is to be removed from the substrate table, thereby allowing a substrate handler of the substrate loading system to easily remove the substrate from the substrate table. An unexposed substrate is then placed on the substrate table WT1 (or WT2), following which the substrate clamp arrangement is switched on.

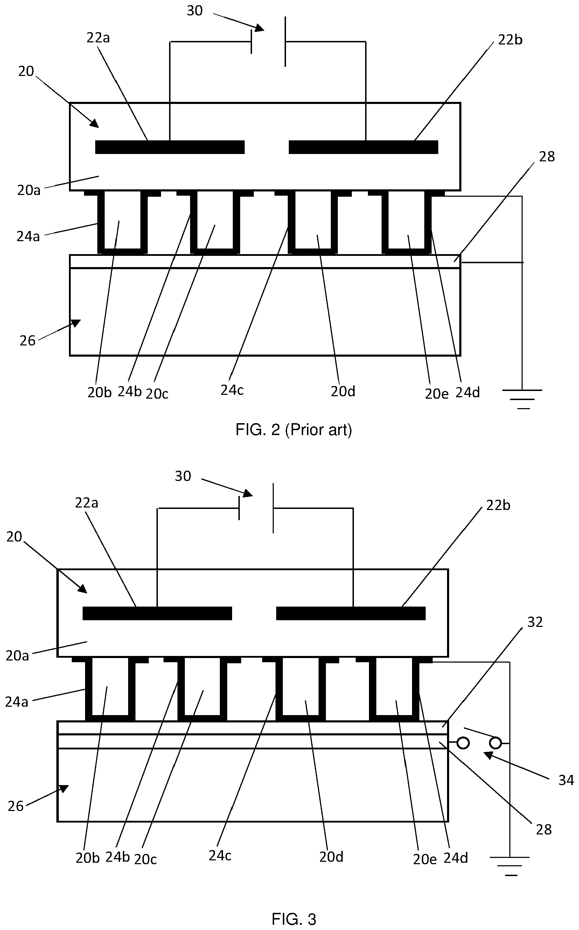

Figure 2 shows a schematic view of a portion of a known substrate clamp arrangement. The portion of the clamp arrangement shown is a portion of an electrostatic clamp arrangement. The clamp arrangement includes a clamp member 20 including first and second electrodes 22a, 22b. In particular, the clamp member 20 comprises a main body 20a (which includes the electrodes 22a, 22b) and a plurality of burls 20b, 20c, 20d and 20e depending from the main body 20a. The electrodes 22a, 22b may form part of an e-sheet located within the clamp member 20. The e-sheet takes the form of the electrodes being encapsulated in a dielectric material. The clamp member 20 also includes a first electrically conductive layer. The first electrically conductive layer takes the form of a plurality of layer portions 24a, 24b, 24c and 24d which are each located on a respective burl such that it can be said that the first electrically conductive layer is located on the plurality of burls 20b to 20e.

The clamp arrangement also includes a mounting member 26 (which may also be referred to as a mirror block - in some applications it may have mirrors mounted to it to facilitate accurate measurement of its position). The mounting member 26 also includes a second electrically conductive layer 28.

In use, the clamp member 20 is mounted on the mounting member 26. Both the first and second electrically conductive layers are electrically connected to earth.

A power supply 30 is connected to each of the electrodes 22a, 22b. In the arrangements shown, the clamping arrangement may be referred to as being bipolar. This is because the power supply 30 is configured to place one of the electrodes 22a at a positive voltage and the other electrode 22b at a negative voltage.

The voltage applied to the electrodes creates an electrostatic force which attracts the clamp member 20 to the mounting member 26, thereby clamping the clamping member to the mounting member 26.

The clamping pressure between the clamp member 20 and mounting member 26 is defined by the equation below:

$$P = \frac{F}{A} = \frac{1}{2}\eta\frac{\varepsilon_0}{\left(g+\frac{d}{\varepsilon_r}\right)}V^2 \quad (1)$$

where

P is the clamping pressure,
F is the electrostatic force,
A is the area over which the electrostatic clamping force is distributed,
$\eta$ is an electrode/barrier ratio,
$\varepsilon_0$ is the dielectric constant of the vacuum between the clamp member 20 and mounting member 26,
$\varepsilon_r$ is the relative dielectric constant of the dielectric material of the e-sheet,
g is the vacuum gap (i.e. the separation between an underside of the main body 20a of the clamp member 20 and the conductive layer 28,
d is the thickness of the dielectric material of the e-sheet (this is the distance between each electrode 22a, 22b and the vacuum gap located between the clamp member 20 and mounting member 26), and
V is the voltage (with respect to earth) applied to each of electrodes 22a, 22b. In the present embodiment, as the electrodes are a bipolar arrangement, each electrode will have the same magnitude of voltage, but the opposite polarity.

In one example d is 100$\mu$m, V is 3200V, g is 10 $\mu$m, $\eta$ is 0.9, and $\varepsilon_r$ is approximately 4. This will result in a clamping pressure of approximately 44 kPa.

It can be seen from the above formula that in order to increase the clamping pressure p it is desirable to either increase the applied voltage or decrease the vacuum gap and/or dielectric thickness. However, increasing the voltage is limited by the operating characteristics of the power supply that powers the electrodes, reducing the dielectric thickness is limited by the dielectric breakdown strength of the dielectric concerned, and reducing the vacuum gap is limited by particle sensitivity and electrostatic charging effects. In addition, higher voltage increases the electric field strength in the (vacuum) gap between the clamp member and the mounting member. This may increase electrostatic risks.

The clamping pressure exerted by the clamping arrangement is a key factor in determining whether, when the substrate table of which the clamping arrangement forms part is accelerated, a clamped substrate and/or clamp member will move relative to the substrate table as a result of the acceleration of the substrate table. It will be appreciated that any movement of the clamped substrate and/or clamp member relative to the substrate table is unacceptable as the location of the substrate and/or clamp member relative to the rest of the lithographic apparatus is critical in ensuring that the substrate is processed correctly. The acceleration of the substrate table is a key factor in determining the processing speed of the lithographic apparatus. In light of this, if it is desired to increase the processing speed of the lithographic apparatus it may be desirable to increase the acceleration of the substrate table and this may be made possible by increasing the clamping pressure of the clamping arrangement.

The present invention seeks to provide an alternative clamping arrangement which provides an increase in clamping pressure without the need to increase the applied voltage or decrease the dielectric thickness and/or vacuum gap.

Figure 3 shows a schematic view of a portion of a clamping arrangement in accordance with an embodiment of the present invention.

Equivalent features within the embodiment shown in Figure 3 to those shown in Figure 2 have been given the same reference numerals. The discussion below focuses only on the differences between the embodiment shown in Figure 3 and prior art shown in Figure 2. Structurally, there are two main differences. First, a dielectric layer 32 is sandwiched between the first electrically conductive layer (24a, 24b, 24c and 24d) and the second electrically conductive layer 28. Secondly, the second electrically conductive layer 28 is no longer electrically connected to ground.

In the embodiment shown a switch 34 is provided which can be used to temporarily electrically connect the second electrically conductive layer 28 to ground - the significance of being able to do so is discussed in more detail further below. However, in other embodiments, a clamp arrangement according to the present invention need not be provided with any way of temporarily grounding the second electrically conductive layer, such that, in these embodiments, the second electrically conductive layer is permanently electrically decoupled from ground.

The dielectric layer 32 is fixed to the second electrically conductive layer 28 such that it forms part of the mounting member 26. In other embodiments, as discussed in more detail further below, this need not be the case.

In addition, in the present embodiment, the dielectric layer is continuous. That is to say, the dielectric layer covers an entire upper surface of the second electrically conductive layer 28. It may be said that the dielectric layer 32 is continuous in that it is configured such that, in use, when the burls (20b, 20c, 20d and 20e) contact the mounting member, the dielectric layer 32 is not only located beneath each of the burls, but also extends beneath the space between adjacent burls.

The second electrically conductive layer 28 may be formed of any appropriate material. Given the requirement that the layer is electrically conductive, it will be clear that the material from which the layer is formed must be electrically conductive. In addition, in order to improve the durability of the clamp arrangement, it is preferable for the material forming the second electrically conductive layer to be relatively hard. For example, the material may have a Mohs hardness of 6.0 or greater or 7.0 or greater. Suitable materials include metals such as Chromium, Tungsten, Vanadium and Titanium.

The first electrically conductive layer (24a, 24b, 24c and 24d), like the second electrically conductive layer 28, also, by its nature, must be formed from an electrically conductive material. Again, to improve the durability of the clamp arrangement, it is preferable that the material is relatively hard. For example, the material may have a Mohs hardness of 6.0 or greater or 7.0 or greater. Example materials include the metals previously mentioned, chromium nitride, silicon carbide, siliconized silicon carbide or conductive diamond, titanium nitride and doped chromium nitrate e.g. CrNAl.

It is desirable that the first conductive layer has a surface roughness in the range of about 1nm to about 10nm. This measure of roughness is the defined as the average height deviation from the mean, which can also be referred to as Ra.

The dielectric layer 32 may be formed from any appropriate dielectric material. As is well known, a dielectric material is one that is an electrical insulator but one that can be polarized by applying an electric field thereto. The dielectric layer may be formed of any appropriate dielectric material. Examples of suitable dielectric material include silicon oxide, diamond, boron nitride, zircon oxide, aluminium nitride, silicon nitride, and aluminium oxide.

The at least one electrode (in this case electrodes 22a and 22b), forms part of an e-sheet arrangement. An e-sheet arrangement takes the form of one or more electrodes (in this case electrodes 22a and 22b), formed of any appropriate electrically conductive material, such as copper, encapsulated in a dielectric material. The dielectric material may be any appropriate dielectric material, for example, quartz.

As previously discussed, the second electrically conductive layer 28 is no longer permanently connected to electrical ground. When the second electrically conductive layer 28 is not connected to electrical ground, the second electrically conductive layer 28 may be said to be at a floating voltage. Given that the second electrically conductive layer 28 is at a floating voltage, the electrostatic potential across the dielectric layer 32 above the second electrically conductive layer 28 of the mounting member results in an additional electrostatic force being applied across the dielectric layer 32 between the mounting member 26 and the clamp member 20.

In the present embodiment the dielectric layer 32 has a thickness of approximately 100nm and the first electrically conductive layer (24a, 24b, 24c and 24d) has a surface roughness of about 10nm. These geometries are significantly less than the geometries of other portions of the clamping arrangement (100$\mu$m for the thickness of the dielectric in the e-sheet and 10$\mu$m for the vacuum gap). This means that a much lower voltage is needed to create significant additional clamping pressure at the interface between the clamping member (and, in particular, the burls of the clamping member) and the mounting member. This is because, as already discussed in relation to equation 1, clamping pressure is inversely proportional to the square of distance.

In light of the above, utilizing a dielectric layer according to the present invention, a greater clamping pressure can be generated with the same voltage, or the same clamping pressure can be obtained with a lesser voltage and/or a clamp member/mounting member having a reduced thickness. Furthermore, the present invention ensures that the clamping force between the clamp member and the mounting member is applied exactly where it is needed - at the interface between the clamp member (and, for example, in particular, the burls of the clamp member) and the mounting member.

Being able to create the same clamping pressure using a reduced voltage or create a greater clamping pressure using the same voltage may be beneficial because one disadvantage of using increased voltage to provide the clamping pressure is that increased voltage also increases the deflection of the main body of the clamping member in between the burls. This may result in an upper surface of the main body of the clamping member becoming un-flat. It will be appreciated that if the clamp member is used to support a wafer for processing by a lithographic apparatus, a degree of un-flatness on the upper surface of the main body of the clamping member may result in the wafer being supported in a non-flat manner. This may result in errors in processing the wafer by the lithographic apparatus.

Further additional clamping pressure can be obtained by, instead of the electrodes of the clamp arrangement being run at a balanced voltage, running the electrodes at a biased voltage. For example, where a bipolar electrostatic clamp has previously been operated at a balanced voltage of +/- 3.2kV, according to the present invention, the power supply may be configured such that the electrodes 22a, 22b operate in a biased manner - for example, a bias of 20V, such that one electrode operates at +3220V and the other electrode operates at -3180V. The bias in the voltage applied to the electrodes results in an electrostatic potential being generated in the floating electrically conductive layer 28 of the mounting block 26. The electrostatic potential induced in the electrically conductive layer 28 results in additional electrostatic attraction between the mounting member and the clamping member.

As previously discussed, in some embodiments, a switch 34 is provided which can temporarily electrically connect the second electrically conductive layer 28 to ground. The ability to ground the electrically conductive layer 28 of the mounting member 26 provides additional control. This is because, when desired, it is possible to place the second electrically conductive layer 28 at an electrostatic potential of 0V. When this occurs, this reduces any electrostatic attractive force caused by induced electrostatic potential in the second electrically conductive layer 28 to zero. This may aid the relative repositioning of the clamp member 20 relative to the mounting member 26 in circumstances where this is desirable - for example, when the clamp member 20 is being installed at a desired position relative to the mounting member 26.

Whereas the switch discussed above is configured to electrically connect the second electrically conductive layer to electrical ground, in other embodiments the switch may, in addition or alternatively, electrically connect the second electrically conductive layer to a set voltage. For example, the switch may connect the second electrically conductive layer to a power supply which drives the second electrically conductive layer to a desired potential relative to ground or the electrodes within the clamp member.

The present invention relies upon an electrostatic potential being created across the interface between the clamp member 20 and mounting member 26, the electrically conducting layers (24a, 24b, 24c, 24d and 28) of which are separated by the dielectric layer 32. The above-described embodiment achieves this by allowing the second electrically conducting layer 28 of the mounting member 26 to be at a floating voltage and therefore allows an electrostatic potential to be induced therein. As will be appreciated by the person skilled in the art, there are various other ways in which a potential can be induced between the clamp member and mounting member. Such methods may be applied as an alternative to or in addition to the floating second electrically conductive layer 28 discussed above. In one example, instead of the second electrically conductive layer 28 of the mounting member 26 being allowed to be at a floating voltage, the second electrically conductive layer 28 may be driven by a power supply such that it is at an offset voltage relative to the voltage of one or more of the electrodes 22a, 22b of the clamp member 20. Another option is placing the first electrically conductive layer (24a to 24d), which is grounded in the discussed embodiment, at an offset voltage relative to the second electrically conductive layer 28 by driving it with an appropriate power supply.

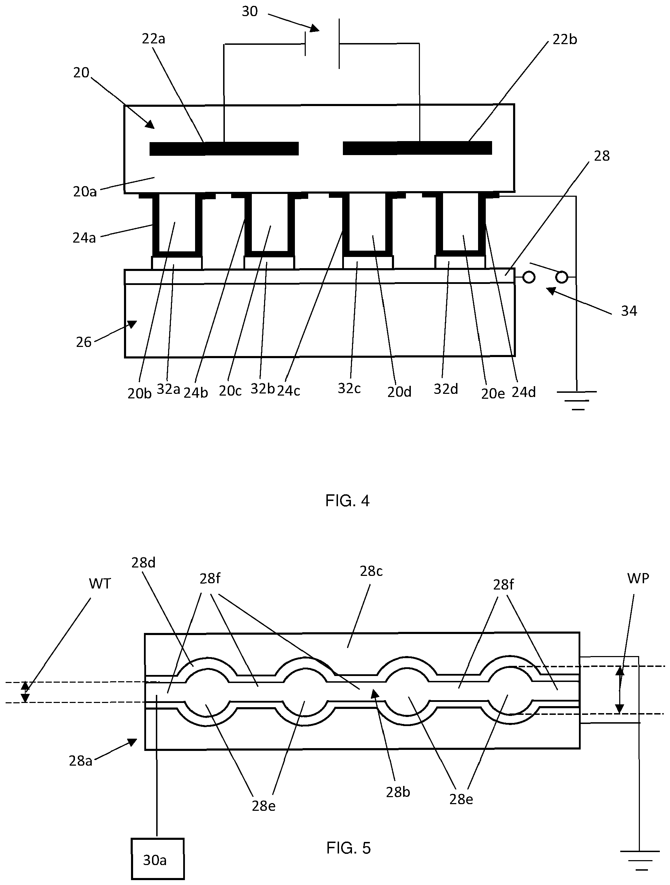

Figure 4 shows a schematic view of a portion of an electrostatic clamp arrangement in accordance with another embodiment of the present invention. Again, equivalent features within this embodiment to those discussed in the previous figures have been given the same reference numerals.

The main difference between the embodiment shown in Figure 4 and that shown in Figure 3 is that instead of the dielectric layer within the embodiment as shown in Figure 4 being continuous over the upper surface of the second electrically conductive layer 28 (as is the case within the embodiment shown in Figure 3), the dielectric layer is discontinuous. In particular, in the embodiment shown in Figure 4, the dielectric layer includes four discrete portions (32a, 32b, 32c and 32d). Given the fact that the portions of the dielectric layer are discrete, the dielectric layer is said to be discontinuous.

As previously discussed, provided the dielectric layer 32a to 32d is sandwiched between the first electrically conductive layer 24a to 24d and a second electrically conductive layer 28, whilst the electrostatic clamp arrangement is in use, the electrostatic clamp arrangement will function in accordance with the invention as previously discussed. It will be appreciated that in some embodiments the portions 32a to 32d of the dielectric layer maybe fixed to (respective portions of) the first electrically conductive layer 24a to 24d. Whereas in other embodiments, the portions of the dielectric layer maybe fixed to the second electrically conductive layer 28. Of these two options, it will be appreciated there is some benefit in fixing the portions of the dielectric layer to the first electrically conductive layer, as opposed to fixing them to the second electrically conductive layer 28. The reason for this is that, when the portions of the dielectric layer are fixed to the first electrically conductive layer, the dielectric layer will be sandwiched between the first and second electrically conductive layers regardless of where the clamp member 20 is positioned on the mounting member 26. To the contrary, if the portions of the dielectric layer are fixed to the second electrically conductive layer 28, it will be necessary, in use, to position the clamp member 20 on the mounting member 26 at a correct location so that the dielectric layer is sandwiched between the first and second electrically conductive layers, as necessary.

Figure 5 shows a schematic view from above of an alternative second electrically conductive layer 28a. Whereas the second electrically conductive layer 28 is shown in relation to the previous described embodiments of the present invention maybe said to be generally continuous (such that the second electrically conductive layer is generally uniform/planar and covers the entirety of an upper surface of the mounting member 26), the second electrically conductive layer 28a shown in Figure 5 maybe said to be discontinuous. In particular, the second electrically conductive layer 28a comprises a first electrically conductive portion 28b which is electrically isolated from a second electrically conductive portion 28c. The first and second electrically conductive portions 28b, 28c are electrically isolated by an intermediate electrically isolating portion 28d which is formed of an electrically isolating (i.e. electrically non-conductive) material.

It can be seen that the first electrically conductive portion 28b is shaped such that it forms a row of pads 28e which are joined by connecting tracks 28f. The pads 28e have a width WP in the plane of the conductive layer which is greater than a width WT of the tracks 28f. The pads 28e are located so that they correspond to the position of the burls of the clamp member when the clamp member 20 is positioned, in use, on top of the mounting member 26.

The first electrically conductive portion 28b may be referred to as the burl-facing portion and the second electrically conductive portion 28c may be referred to as the space-facing portion. As previously discussed, it will be appreciated that the burl-facing portion 28b, in use, faces a corresponding burl (20b to 20e) of the clamp member 20 which is located above the respective pads 28e of the first electrically conductive portion 28b. The space-facing portion 28c of the electrically conductive layer 28a, in use, faces a space between adjacent burls (20b to 20e) of the clamp member 20, said spaces being located above the space-facing portion 28c of the electrically conductive layer 28a.

In an embodiment such as that currently shown, in use, it is envisaged that the space-facing portion 28c will be electrically connected to ground. It is also envisaged that the burl-facing portion 28b will be electrically connected to a power supply 30a which is capable of placing the electrically conductive portion 28b at a bias potential. Any appropriate bias potential maybe used to generate a desired clamping force between the mounting member 26 and clamp member 20. In one embodiment the electrically conductive portion 28b is placed at a bias potential of 100V.

An advantage of this arrangement is that by making the electrically conductive layer 28a of the mounting block discontinuous, this enables the relevant portions of the conductive layer which are located directly underneath the burls (in this case the pads 28e) to be placed at a bias potential whilst leaving the portions (in this case the second electrically conductive portion 28c) of the electrically conductive layer which are located directly underneath the spaces between the burls electrically grounded. This ensures that the electrostatic attractive force created between the mounting member 26 and clamp member 10 is predominantly an electrostatic force exerted between each burl (20b to 20e) and the corresponding portion of the burl-facing electrically conductive portion of the electrically conductive layer 28a. This reduces the electrostatic pressure exerted on a main body of the mounting member 26 located beneath the electrically conductive layer 28a and thereby reduces possible wear on the main body of the mounting member. Wear of the main body of the mounting member may eventually lead to inaccurate location of the clamping member 20 relative to the mounting member 26 and therefore of any wafer clamped by the clamping member 20. As such, wear is undesirable as it may require repair, refurbishment or replacement of the mounting member.

In the above embodiments of the invention where it is contemplated that a dielectric layer is sandwiched between the mounting member and clamping member, the dielectric layer is only attached to one of i) a portion of the mounting member (e.g. on an upper surface of the second conductive layer) or ii) a portion of the clamping member (e.g. on a lower surface of first electrically conductive layer). However, it is also possible that the dielectric layer is formed of two portions - a first portion which is fixed to a portion of the clamping member and a second portion which is fixed to a portion of the mounting member. In use, the first portion fixed to the clamping member contacts the second portion fixed to the mounting member such that both the first portion fixed to the clamping member and the second portion fixed to the mounting member are sandwiched between the clamping member and the mounting member.

Whereas the presently described embodiments take the form of a clamping member being relatively one dimensional in that it comprises a row of burls of the clamping member located along a corresponding portion of the mounting member. In other embodiments the clamp arrangement maybe relatively two dimensional such that the burls of the clamping member form a two dimensional array with rows and columns of burls which locate themselves across a corresponding relatively two dimensional surface of the mounting member. In this situation it will be appreciated that not only do the rows and columns of burls form a relatively two dimensional array, but also the spaces between adjacent burls have a footprint which is relatively two dimensional - having width and depth - such that the footprint is generally rectangular such that the space defined by the footprint is generally cuboidal.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference has been made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatuses may be generally referred to as lithographic tools. Such a lithographic tool may use vacuum conditions or ambient (non-vacuum) conditions. A substrate clamp according to an embodiment of the invention may form part of a lithographic tool.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

**Claims**

1. An electrostatic clamp arrangement comprising:

   a clamp member comprising at least one electrode and a first electrically conductive layer;
   a mounting member, comprising a second electrically conductive layer, upon which the clamp member is mounted; and
   a dielectric layer sandwiched between the first and second electrically conductive layers.

2. An electrostatic clamp arrangement according to claim 1, wherein the dielectric layer is fixed to second electrically conductive layer; and, optionally, wherein the dielectric layer is discontinuous.

3. An electrostatic clamp arrangement according to claim 1, wherein the dielectric layer is fixed to first electrically conductive layer.

4. An electrostatic clamp arrangement according to any preceding claim, wherein the clamp member comprises a main body which includes the at least one electrode, and a plurality of burls depending from the main body, wherein the first electrically conductive layer is located on said plurality of burls.

5. An electrostatic clamp arrangement according to any preceding claim, wherein the second electrically conductive layer is formed of chromium.

6. An electrostatic clamp arrangement according to any preceding claim, wherein the first electrically conductive layer is formed of chromium nitride.

7. An electrostatic clamp arrangement according to any proceeding claim, wherein the dielectric layer is formed of silicon oxide.

8. An electrostatic clamp arrangement according to any proceeding claim, further comprising a power supply, wherein the power supply is electrically connected to the at least one electrode.

9. An electrostatic clamp arrangement according to any proceeding claim, wherein the first electrically conductive layer is electrically connected to ground.

10. An electrostatic clamp arrangement according to any proceeding claim, wherein the second electrically conductive layer is electrically connected to electrical ground or electrically connected to a power supply configured to place the second electrically conductive layer at a desired non-ground voltage.

11. An electrostatic clamp arrangement according to any proceeding claim wherein the second electrically conductive layer is discontinuous such that it comprises first and second electrically conductive portions that are electrically isolated from each other.

12. An electrostatic clamp arrangement according to any proceeding claim, further comprising a switch which is electrically connected to the second electrically conductive layer and to ground, the switch having a first configuration in which the switch does not electrically connect the second electrically conductive layer to ground, and a second configuration in which the switch electrically connects the second electrically conductive layer to ground.

13. An electrostatic clamp arrangement according to claim 8 or any claim dependent on claim 8, wherein the at least one electrode comprises a first electrode and a second electrode, wherein the power supply is connected to the first and second electrodes and wherein the power supply is configured to place the first electrode at a first positive voltage and place the second electrode at a second negative voltage, wherein the first and second voltages are not the same such that there is an offset between the first and second voltages.

14. An electrostatic clamp arrangement according to any preceding claim except claim 12 or any claim dependent on claim 12, wherein the second electrically conductive layer is electrically connected to a power supply configured to place the second conductive layer at a desired non-ground voltage.

15. A lithographic apparatus comprising an electrostatic clamp arrangement according to any preceding claim.

FIG. 1

FIG. 2 (Prior art)

FIG. 3

FIG. 4

FIG. 5

Europäisches
Patentamt

European
Patent Office

Office européen
des brevets

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2020/326635 A1 (SOETHOUDT ABRAHAM ALEXANDER [NL] ET AL) 15 October 2020 (2020-10-15) | 1,3,5-8, 15 | INV. G03F7/20 H01L21/683 |
| A | * paragraphs [0087] – [0089]; figure 8 * ----- | 2,4,9-14 | H01L21/687 |
| Y | US 2018/005860 A1 (MIYAMOTO KAZUYOSHI [JP] ET AL) 4 January 2018 (2018-01-04) | 1,3,5-8, 15 | |
| A | * paragraphs [0017] – [0036]; figure 2 * ----- | 2,4,9-14 | |
| A | EP 4 206 822 A1 (ASML NETHERLANDS BV [NL]) 5 July 2023 (2023-07-05) * paragraphs [0056] – [0061]; figure 6 * ----- | 1-15 | |

|  |
|---|
| TECHNICAL FIELDS SEARCHED (IPC) |
| G03F H01L |

The present search report has been drawn up for all claims

| Place of search | Date of completion of the search | Examiner |
|---|---|---|
| Munich | 8 December 2023 | Eisner, Klaus |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

....................................................................

& : member of the same patent family, corresponding
    document

EPO FORM 1503 03.82 (P04C01)

**ANNEX TO THE EUROPEAN SEARCH REPORT
ON EUROPEAN PATENT APPLICATION NO.**

EP 23 18 3982

This annex lists the patent family members relating to the patent documents cited in the above-mentioned European search report.
The members are as contained in the European Patent Office EDP file on
The European Patent Office is in no way liable for these particulars which are merely given for the purpose of information.

08-12-2023

| Patent document cited in search report | Publication date | Patent family member(s) | Publication date |
|---|---|---|---|
| US 2020326635 A1 | 15-10-2020 | CN 111406235 A | 10-07-2020 |
| | | EP 3714329 A1 | 30-09-2020 |
| | | JP 7121122 B2 | 17-08-2022 |
| | | JP 2021503103 A | 04-02-2021 |
| | | JP 2022145719 A | 04-10-2022 |
| | | KR 20200067200 A | 11-06-2020 |
| | | KR 20220143173 A | 24-10-2022 |
| | | NL 2021871 A | 22-05-2019 |
| | | TW 201923959 A | 16-06-2019 |
| | | TW 202131446 A | 16-08-2021 |
| | | TW 202243099 A | 01-11-2022 |
| | | US 2020326635 A1 | 15-10-2020 |
| | | US 2022082952 A1 | 17-03-2022 |
| | | WO 2019096554 A1 | 23-05-2019 |
| US 2018005860 A1 | 04-01-2018 | JP 6703907 B2 | 03-06-2020 |
| | | JP 2018006559 A | 11-01-2018 |
| | | US 2018005860 A1 | 04-01-2018 |
| EP 4206822 A1 | 05-07-2023 | EP 4206822 A1 | 05-07-2023 |
| | | WO 2023126112 A1 | 06-07-2023 |

EPO FORM P0459

For more details about this annex : see Official Journal of the European Patent Office, No. 12/82